# EUROPEAN PATENT APPLICATION

(11) **EP 4 800 152 A1**
(43) Date of publication of application: **02.09.2026**
(21) Application number: 25160858.4
(22) Date of filing: 28.02.2025
(51) Int. Cl.: C23C 16/04, B08B 9/00, B22F 12/53, B29C 64/159, B29C 64/209, B33Y 10/00, B33Y 30/00, C23C 16/44, C23C 16/455, H01J 37/32, H01L 21/67

(54) **AN ATOMIC LAYER PROCESS PRINTER FOR MATERIAL DEPOSITION, ETCHING, DOPING AND/OR CLEANING AND A PRINTER HEAD ARRANGEMENT FOR ENABLING PRINTING**

(71) Applicant: Atlant 3D ApS, 2630 Taastrup (DK)
(72) Inventor: NAVNE, Jesper, 2700 Brønshøj (DK); BARAKET, Mira, 2625 Vallensbaek (DK); PLAKHOTNYUK, Maksym, 2800 Kongens Lyngby (DK)
(74) Representative: Zacco Denmark A/S

(57) **Abstract**

An atomic layer process printer for material deposition, etching, doping and/or cleaning on an atomic scale in a selective area is disclosed. The printer comprising: a substrate holder for holding a substrate where onto one or more fluids are deposited; a printer head positioned opposite the substrate holder, wherein the printer head comprises a printer head arrangement and a printer head body, the printer head arrangement comprising an array of nozzles, wherein each nozzle comprises an integer number of openings comprising: a first exit opening ; wherein the printer head arrangement comprises an integer number of fluid distribution arrangements comprising: a first fluid distribution arrangement arranged to deposit a first fluid to the substrate via the first exit opening of each of the nozzles; the printer head body comprising: a first inlet supply channel in fluid communication with the first exit opening via the first fluid distribution arrangement.

## Description

### Technical field

The present disclosure relates to an atomic layer process printer for material deposition, etching, doping and/or cleaning and a printer head arrangement for enabling the same. More specifically, the disclosure relates to an atomic layer process printer for material deposition, etching, doping and/or cleaning and a printer head arrangement for enabling material deposition, etching, doping and/or cleaning as defined in the introductory parts of the independent claims.

### Background art

Atomic layer processing involves a series of controlled, cyclic steps where reactants are introduced to interact with the surface of a substrate.

Atomic Layer Deposition (ALD) is an example of an atomic layer processing technique used as a nanoscale manufacturing tool for printing of continuous films on surfaces. The principle behind ALD is that the surface is subjected to a first precursor gas, which adsorbs on the surface, afterwards the excess first precursor gas is evacuated and after full evacuation of the excess first precursor gas the second precursor gas is introduced, completing the reaction on the surface. In general, ALD relies on two or multistep reactions to control the deposition process. The ALD can be operated in two manners; a temporal ALD and a spatial ALD. Overall, spatial ALD separates the different gases in space whereas temporal ALD separates the gases in time.

Similarly, Atomic Layer Etching (ALE) can be used for etching at the nanometer scale. ALE is a precise and controlled process that mirrors the principles of ALD, but instead of adding material, it removes material layer by layer. Thus, ALD and ALE share a common approach of using sequential, self-limiting reactions to achieve precise control at the atomic level.

Atomic layer processing therefore offers advanced techniques essential for modern semiconductor manufacturing, offering atomic-level precision and control. By way of example, ALD allows for the deposition of ultra-thin, uniform films on complex 3D structures, ensuring low defect density and material versatility. This makes ALD ideal for applications such as transistor fabrication, interconnects, and memory devices. ALE, on the other hand, provides precise, selective, and uniform etching capabilities, crucial for creating nanoscale features and maintaining the integrity of advanced materials like high-k dielectrics and metal gates.

Atomic layer processing is indispensable for achieving the precision required in the production of smaller, faster, and more efficient electronic devices, making the processing integral to the advancement of semiconductor technology.

In the context of 3D printing, ALD can enhance the properties of printed parts by improving the oxidation resistance, and mechanical strength of the materials used.

There exists a number of prototyping and additive nanoscale manufacturing tools. However, they often have difficulties including low processing speed, problems operating at atmospheric conditions, an excessive usage of materials, and complexity to process different materials simultaneously. Further, many of the existing methods requires high price of tools.

To achieve this, WO2020245230 discloses an atomic layer process printer for material deposition, etching, doping and/or cleaning on an atomic scale in a selective area. WO2020245230 describes a method for material deposition, etching, doping and/or cleaning on an atomic scale in a selective area using the atomic layer process printer. In more detail, a printer is described with the possibility of move the substrate plate and the printer head in relation to each other at a full 3D orientation. This arrangement opens up for the creation of 3D structures in an easy manner at the same time as providing an atomic scale resolution at least in the direction perpendicular to the substrate. This results in a state-of-the-art printer based on the principles of spatial ALD technology. Put differently, by making the substrate plate movable and tiltable in relation to the printer head an improved control of a 3D geometry of the printed structure is obtainable.

There is, however, a need for improvements, particularly in achieving larger throughput, high resolution and in overall more efficient printers enabling three-dimensional printing technologies with higher speed and control. There is further a need for ALD systems and methods for enhancing the precision and uniformity of deposited materials such as thin films, lines or points, especially for complex three-dimensional structures in semiconductor devices. This includes improving the conformality and reducing the defect density of deposited layers. Similarly, there is a need for refinement of ALE processing techniques to offer more precise and selective etching capabilities, which are valuable for the intricate patterns required in advanced semiconductor devices. Put differently, there is a need for improvements aiming to achieve higher resolution and better control over the etching process, ensuring that even the smallest features are accurately defined.

Overall, continued improvements in both ALD and ALE processes and tools are essential to meet the increasing demands for higher resolution and the integration of these techniques with emerging technologies like three-dimensional printing which provides high resolution three-dimensional structures at the atomic or nanometer scale.

### Summary

It is an object of the present disclosure to mitigate, alleviate or eliminate one or more of the above-identified deficiencies and disadvantages in the prior art and solve at least the above-mentioned problems.

According to a first aspect there is provided an atomic layer process printer for material deposition, etching, doping and/or cleaning on an atomic scale in a selective area, the printer comprising: a substrate holder for holding a substrate where onto one or more fluids are deposited using the atomic layer process printer; a printer head positioned opposite the substrate holder, the substrate holder being movable in relation to the printer head; wherein the printer head comprises a printer head arrangement and a printer head body, the printer head arrangement comprising an array of nozzles, wherein each nozzle comprises an integer number, n, of openings, the openings comprising: a first exit opening; wherein the printer head arrangement further comprises an integer number, m, of fluid distribution arrangements, the fluid distribution arrangements comprising: a first fluid distribution arrangement arranged to deposit a first fluid to the substrate via the first exit opening of each of the nozzles; wherein the printer head body comprises: a first inlet supply channel in fluid communication with the first exit opening via the first fluid distribution arrangement.

An advantage may be that a more versatile and efficient atomic layer process printer may be provided. A further advantage may be that a plurality of lines can be produced at the same time in parallel and/or that a single line may be printed or etched multiple times in one scanning motion of the printer. The lines produced may comprise deposited material. A faster writing may thereby be provided. Put differently, each of the nozzles may have one or more openings for "3D printing" on a substrate on the atomic scale. The fluid distribution arrangement may be arranged to deposit the fluid to the substrate via the exit openings of the nozzles in an efficient manner. Parallel lines may be printed.

Put differently, the first fluid distribution channel may be arranged to guide the first fluid onto the substrate through one or more first exit openings.

A further advantage may be that the printer allows for multiple depositions in the same pass or faster deposition depending on the configurations of the array of nozzles. Multiple nozzles having different geometries and/or opening sizes may allow for a customisable line profile that together may form a desired deposition or etching pattern. To this end, the above advantages may be achieved without expanding the footprint of the printer head arrangement. The fluid distribution arrangements further may increase the uniformity of the distribution of fluid. A more reliable, and efficient printer may thereby be achieved.

According to some examples, the substrate holder may be arranged to be movable along an axis in an X,Y plane defined by an X axis and an Y axis being perpendicular in relation to each other. The substrate holder may further be movable along a Z axis being perpendicular to the X,Y plane.

According to some examples, the substrate holder may be movable at a first angle ϕ defining a rotation of the X,Y plane around the Z axis.

According to some examples, the substrate holder and the printer head may be movable in relation to each other at a second angle θ defining a tilting of the X,Y plane around an axis in the X,Y plane. This feature of tilting of the X, Y plane around an axis in the X, Y plane may be used to adjust the printer head to be as perpendicular to the substrate holder as possible.

According to some examples, the printer head may be stationary in relation to the substrate holder. In other words, the sample may be scanned in relation to a fixed position of the printer head. According to some examples, the first exit opening may have a diameter in a range of 0.005-900 micrometers.

The integer number, n, of openings may according to some examples comprise only one opening. The nozzle may according to other examples comprises a plurality of openings. Put differently, the integer number of openings, n may be 1, i.e. n=1. The integer number of openings may be n>1. By way of example, n may be equal to 2 or 3. According to some examples n may be larger than 3, i.e. n>3. To this end, the printer head arrangement may comprise an integer number, m, of fluid distribution arrangements.

The integer number, m, of fluid distribution arrangements may according to some examples comprise only one fluid distribution arrangement. The printer head arrangement may according to other examples comprises a plurality of fluid distribution arrangements. Put differently, the integer number of fluid distribution arrangements, m may be 1, i.e. m=1. The integer number of fluid distribution arrangements may be m>1. By way of example, m may be equal to 2 or 3. According to some examples m may be larger than 3, i.e. m>3.

According to some examples, the number of openings may be the same as the number of fluid distribution arrangements, i.e. n=m.

According to some examples, the openings further comprise: a second exit opening; a third exit opening; and wherein the fluid distribution arrangements further comprise: a second fluid distribution arrangement arranged to deposit a second fluid to the substrate via the second exit opening of each of the nozzles; and a third fluid distribution arrangement arranged to distribute an inert fluid to the substrate via the third exit opening of each of the nozzles; wherein the printer head body further comprises: a second inlet supply channel in fluid communication with the second exit opening via the second fluid distribution arrangement; a third inlet supply channel in fluid communication with the third exit opening via the third fluid distribution arrangement.

Put differently, the first, second and third fluid distribution arrangements may be arranged to distribute one or more of the fluids and/or the inert fluid to the substrate via the corresponding exit openings of the array of nozzles.

According to some examples, the second exit opening may have a diameter in a range of 0.005-900 micrometers.

According to some examples, the third exit opening may be larger than the first and/or the second exit openings.

According to some examples, the third exit opening may have a diameter less than 2 millimeters.

According to some examples, the printer head arrangement comprises: an exhaust collector arrangement arranged to collect and remove non-deposited first and second fluids and inert fluid from the substrate via one or more exhaust openings of each nozzle; and wherein the printer head body comprises: one or more outlet channels in fluid communication with the exhaust openings via the exhaust collector arrangement.

An advantage may be that a removal of non-deposited material enables an ALD process to be repeated and a more effective removal of non-deposited material is achieved for each of the nozzles.

According to some examples, each of the fluid distribution arrangements comprises a fluid distribution channel and a common fluid chamber, the common fluid chamber being in fluid communication with the fluid distribution channel and being arranged to distribute the first fluid, the second fluid or the inert fluid, to all nozzles of the array of nozzles.

An advantage may be that a more effective and even distribution of fluids is provided to each of the nozzles. A more uniform printing may be provided for each of the nozzles in the array of nozzles.

According to some examples, the first fluid distribution arrangement comprises a fluid distribution channel and a common fluid chamber, the common fluid chamber being in fluid communication with the fluid distribution channel and being arranged to distribute the first fluid to all nozzles of the array of nozzles.

According to some examples, the second fluid distribution arrangement comprises a fluid distribution channel and a common fluid chamber, the common fluid chamber being in fluid communication with the fluid distribution channel and being arranged to distribute the second fluid to all nozzles of the array of nozzles.

According to some examples, the first fluid is a first precursor fluid.

According to some examples, the second fluid is a second precursor fluid.

According to some examples, the common fluid chamber comprises one or more fluid flow dividers arranged to disperse, within the common fluid chamber, fluid from the fluid distribution channel to the nozzles of the array of nozzles.

An advantage being that a more effective and even distribution of fluids is provided to each of the nozzles. A more uniform printing may be provided for each of the nozzles in the array of nozzles.

According to some examples, the common fluid chamber comprises: an outer chamber; a distribution wall; and an inner chamber; wherein the outer chamber is in fluid communication with the fluid distribution channel and the distribution wall separates the inner chamber from the outer chamber, the distribution wall comprising fluid passages for fluid communication between the outer chamber and the inner chamber.

An advantage may be that a more effective and even distribution of fluids is provided to each of the nozzles.

According to some examples, the fluid distribution channel is Y-shaped whereby two channels are in fluid communication with the common fluid chamber.

According to some examples, the fluid distribution arrangements are stacked on top of each other within the printer head arrangement.

An advantage may be that a smaller footprint, e.g. a smaller printer head may be achieved.

According to some examples, the array of nozzles comprises two or more nozzles arranged in a row.

An advantage may be that a more versatile and faster printing may be achieved.

According to some examples, the printer head arrangement is formed in one piece of material.

An advantage may be that a more robust printer head arrangement is provided. A printer head that is more resistible to temperature changes may moreover be provided.

According to some examples, the printer head arrangement is removably attached to the printer head body such that printer head arrangement can be interchangeably connected to the printer head body.

An advantage may be that a removable or replaceable printer head arrangement is provided. The removable printer head arrangement may allow for interchangeable printer head arrangements. A printer that is easier to maintain and/or clean may further be provided. By way of example, multiple printer head arrangements, each having different nozzle arrays and/or openings of different sizes may be used interchangeably in the printer.

According to some examples, the printer head arrangement may be formed by a printer head plate and an additional printer head plate.

According to some examples, the printer head plate and/or the additional printer head plate is removably attached to the printer head body such that different printer head plates can be connected to the printer head body.

According to a second aspect there is provided a printer head arrangement for enabling material deposition, etching, doping and/or cleaning on an atomic scale in a selective area of a substrate when used in an atomic layer process printer, the printer head arrangement comprising an array of nozzles, each nozzle comprising an integer number, n, of openings, the openings comprising: a first exit opening; and wherein the printer head arrangement further comprises: a first fluid distribution arrangement arranged to deposit a first fluid to the substrate via the first exit opening of each of the nozzles.

According to some examples, the openings further comprise: a second exit opening; and a third exit opening; wherein the printer head arrangement further comprises: a second fluid distribution arrangement arranged to deposit a second fluid to the substrate via the second exit opening of each of the nozzles; a third fluid distribution arrangement arranged to distribute an inert fluid to the substrate via the third exit opening of each of the nozzles.

The printer head arrangement may further comprise: an exhaust collector arrangement arranged to collect and remove non-deposited first and second fluids and the inert fluid from the substrate via one or more exhaust openings of each of the nozzles.

Each of the fluid distribution arrangements may comprise a fluid distribution channel and a common fluid chamber, the common fluid chamber being in fluid communication with the fluid distribution channel and being arranged to distribute the first fluid, the second fluid or the inert fluid, to all nozzles of the array of nozzles.

Effects and features of the second aspect are to a large extent analogous to those described above in connection with the first aspect. Embodiments mentioned in relation to the first aspect are largely compatible with the second aspect.

The present disclosure will become apparent from the detailed description given below. The detailed description and specific examples disclose preferred examples of the disclosure by way of illustration only. Those skilled in the art understand from guidance in the detailed description that changes and modifications may be made within the scope of the disclosure.

Hence, it is to be understood that the herein disclosed disclosure is not limited to the particular component parts of the device described or steps of the methods described since such device and method may vary. **It** is also to be understood that the terminology used herein is for purpose of describing particular examples only, and is not intended to be limiting. **It** should be noted that, as used in the specification and the appended claims, the articles "a", "an", "the", and "said" are intended to mean that there are one or more of the elements unless the context explicitly dictates otherwise. Thus, for example, reference to "a unit" or "the unit" may include several devices, and the like. Furthermore, the words "comprising", "including", "containing" and similar wordings do not exclude other elements or steps.

### Brief descriptions of the drawings

The above objects, as well as additional objects, features and advantages of the present disclosure, will be more fully appreciated by reference to the following illustrative and non-limiting detailed description of examples of the present disclosure, when taken in conjunction with the accompanying drawings.
Figure 1 illustrates schematically an atomic layer process printer for material deposition, etching, doping and/or cleaning on atomic scale in a selective area.
Figures 2A, 2B and 2C show an example of a printer head shown in a perspective view (Figure 2A), in a bottom-up view (Figure 2B) and a close-up (Figure 2C).
Figures 3A and 3B show an example of printer head comprising an additional printer head plate in a perspective view (Figure 3A) and in a bottom-up view (Figure 3B).
Figure 4 shows an example of a printer head in an exploded view.
Figure 5A shows an example of a printer head arrangement comprising fluid distribution arrangements and an exhaust collector arrangement stacked in a perspective view.
Figure 5B shows an example of an array of nozzles and a distribution wall in a bottom-up view.
Figure 6 shows an example of an array of nozzles and fluid flow dividers in a bottom-up view.
Figure 7 shows an example of a Y-shaped fluid distribution channel.
Figure 8 illustrates schematically a nozzle comprising exit openings in fluid communication with inlet supply channels via fluid distribution arrangements.
Figure 9 shows an example of exit openings of a nozzle formed as rings.
Figure 10A illustrates schematically printing with an array of nozzles comprising three nozzles.
Figure 10B shows schematically six different arrays of nozzles according to some examples.
Figure 10C shows three spatially separate lines and a single continuous line obtained using a printer comprising an array of three nozzles.

### Detailed description

The present disclosure will now be described with reference to the accompanying drawings, in which preferred examples of the disclosure are shown. The disclosure may, however, be embodied in other forms and should not be construed as limited to the herein disclosed examples. The disclosed examples are provided to fully convey the scope of the disclosure to the skilled person.

Atomic Layer Deposition (ALD) is an example of a method used as a nanoscale manufacturing tool for printing of continuous films on a surface. The principles behind ALD is that the surface is subjected to a first precursor gas, which adsorbs on the surface, afterwards the excess first precursor gas is evacuated and after full evacuation of the excess first precursor gas the second precursor gas is introduced, completing the reaction on the surface. In general, ALD relies on two-step or multistep reactions to control the deposition process. The ALD can be operated in two manners; a temporal ALD and a spatial ALD. Overall, spatial ALD separates the different gases in space whereas temporal ALD separates the gases in time.

The temporal ALD utilizes a chamber, wherein a substrate is positioned. The substrate in the chamber is typically subjected to a first precursor fluid, which adsorbs on the surface, subjected to an inert fluid for cleaning the chamber, subjected to a second precursor fluid, which reacts with the first precursor fluid on the surface, and is subjected to an inert fluid for cleaning the chamber. Non-deposited and/or additional fluids, such the inert fluid may further be removed by evacuation, e.g. through one or more exhaust collector arrangements. The ALD process may be repeated, or combined with other processes, until the desired product is obtained. Temporal ALD is often considered a slow method and requires a large amount of fluids as the entire chamber is to be filled in each step. The spatial selectivity is not inherently possible. The precursor fluid may in some examples be a precursor gas.
Spatial ALD performs the same type of steps as the temporal ALD. However, instead of using a chamber for depositing material on a surface, spatial ALD uses a spatial separation of the gases and instead moves the sample relative to the printer head in the X, Y direction. Depending on the setup either the printer head moves or the sample moves.
Using spatial ALD allows for a faster depositing compared to temporal ALD, and normally a reduction in the amount of gas used is obtained as the deposition occurs locally instead of in one lager chamber. With spatial ALD, the need for emptying the chamber between each dose of a gas is further removed.
Independently of whether temporal ALD or spatial ALD is used, providing a three-dimensional structure is not possible. There is therefore a need for a three-dimensional structuring system, which provides high resolution nanoscale three dimensional structures.

To enable this, an atomic layer process printer for material deposition, etching, doping and/or cleaning on an atomic scale in a selective area is disclosed herein. The printer may comprise a substrate plate for holding a substrate where onto one or more fluids are deposable using the printer, and a printer head positioned opposite the substrate on the substrate holder.

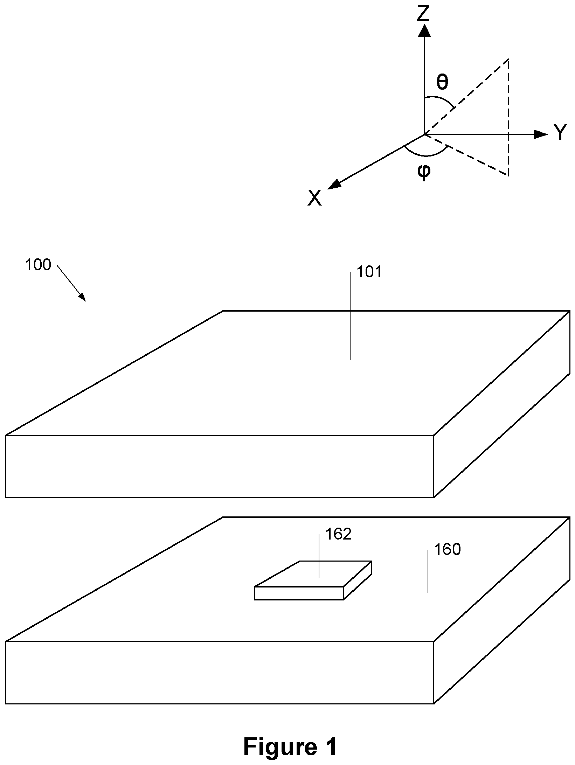

Figure 1 illustrates very schematically an atomic layer process printer 100 as disclosed herein for material deposition, etching, doping and/or cleaning on an atomic scale in a selective area. The printer 100 comprises a substrate holder 160 for holding a substrate 162 and a printer head 101 positioned opposite the substrate 162 on the substrate holder 160. The X, Y, and Z axes are illustrated in the top right corner of Figure 1. Also, the first angle ϕ defining a rotation of the X,Y plane around the Z axis, and the second angle θ defining a tilting of the X,Y plane around an axis in the X,Y plane are illustrated in the top right corner of Figure 1. The substrate plate 160 and the printer head 101 are movable in relation to each other in one or more of the X,Y plane and/or along the Z axis around the two angles ϕ and θ. Put differently, the sample and/or the printer head may be movable in the X,Y plane and/or along the Z axis. In this manner a full 3D movement is obtainable. The printer head may be stationary and the sample may be movable.

The printer 100 will normally operate in a bottom-up set where the printer head 101 is positioned above the substrate holder 160 as shown in Figure 1. Normally, the substrate holder 160 will be moving in the X,Y plane and/or along the Z axis. A movement around the two angles ϕ and θ is possible. The printer head 101 may be kept stationary. However, according to some examples the movement of the printer head 101 can also be envisioned while the substrate holder 160 is kept stationary. Alternatively, movement of both the substrate holder 160 and the printer head 101 simultaneously may also be possible.

As shown in Figure 1, the X,Y plane can be extending in parallel with the substrate holder 160. The rotation of the X,Y plane around the Z axis may therefore be a rotation of the substrate holder 160. Normally the substrate 162 is fixed to the substrate holder 160. The tilting of the X,Y plane may be a tilting of the substrate holder 160 in relation to the printer head 101. Any movement of the substrate holder will therefore translate to a movement of the substrate 162.

The Z axis extends between the printer head 101 and the substrate holder 160 defining a distance between the printer head 101 and the substrate holder 160. The distance between the printer head 101 and the substrate holder 160 may be in a range of 0.005-500 µm, such as 0.005-50 µm, such as 0.01-50 µm, such as 0.05-50 µm, such as 0.1-50 µm, such as 0.1-25 µm, such as 1-10 µm, or such as 50-200 µm.

The distance between the printer head 101 and the substrate holder 160 is variable during printing of a three-dimensional structure. The substrate holder 160 and the printer head 101 may be movable in relation to each other in two or more of: along axis in the X,Y plane; along the Z axis; the first angle ϕ; and the second angle θ. Alternatively, the substrate holder 160 and the printer head 101 are movable in relation to each other. The distance between the printer head 101 and the substrate holder 160 may also be varied during printing of a three-dimensional structure.

The printer 100 is adapted for operating at atmospheric pressure. However, the printer 100 may alternatively be adapted for operating at vacuum or ultra-high vacuum.

The printer 100 is normally adapted for operating at temperatures between 10-600°C, such as between 15-450°C, such as between 20-400°C. The printer will normally comprise a heating source heating at least the printer head to allow for it to operate at a requested temperature. According to some examples, the substrate holder may be heated. The temperature of the substrate holder may be the same or different than the temperature of the printer head.

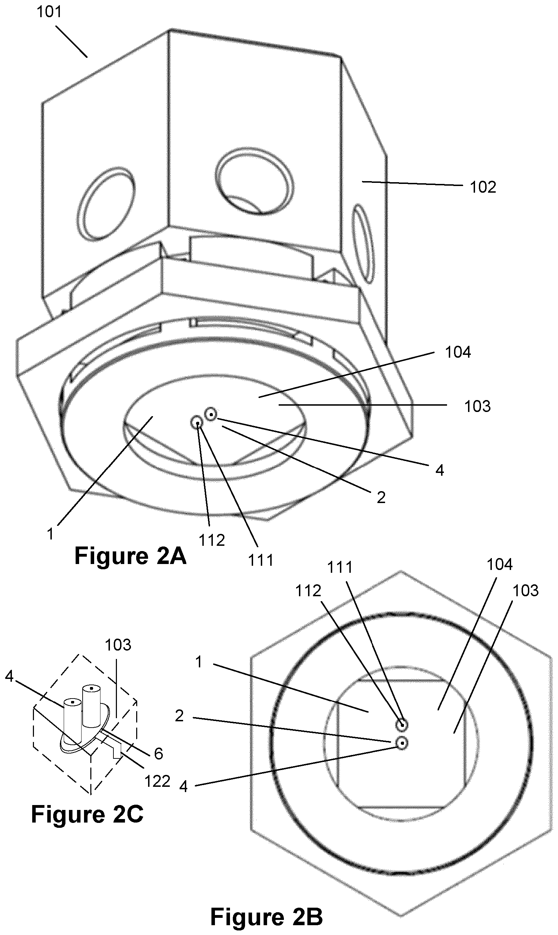

Now referring to Figures 2A, 2B and 2C, an example of a printer head 101 is shown in a perspective view (Figure 2A), a bottom-up view (Figure 2B) and a close-up (Figure 2C). The printer head 101 comprises a printer head arrangement 1 and a printer head body 102. The printer head arrangement 1 comprises an array of nozzles 2. The array of nozzles 2 comprises two or more nozzles 4 arranged in a row, wherein each nozzle 4 comprises an integer number, n, of openings 111. The number of openings is here illustrated to be 1, i.e. n=1, but could in other examples be more than one, i.e. n>1.

The printer head arrangement 1 illustrated to be formed in one piece of material 103.

The printer head arrangement 1 may be formed by zirconia (ZrO₂), alumina (Al₂O₃), silicon carbide (SiC), silicon nitride (Si₃N₄), quartz, or silicon dioxide (SiO₂).

Put differently, the printer head arrangement 1 may comprise one or more materials selected from a group consisting of zirconia (ZrO₂), alumina (Al₂O₃), silicon carbide (SiC), silicon nitride (Si₃N₄), quartz, and silicon dioxide (SiO₂).

The printer head arrangement 1 may be formed by plastics including high-performance polymers, such as polyetheretherketone (PEEK), polytetrafluoroethylene (PTFE), and polyimides (PI).

Put differently, the printer head arrangement 1 may comprise one or more materials selected from a group consisting of polyetheretherketone (PEEK), polytetrafluoroethylene (PTFE), and polyimides (PI).

It may be noted that the printer head arrangement 1 may be formed by a printer head plate 104.

The printer head arrangement 1 may be removably attached to the printer head body 102 such that printer head arrangement 1 can be interchangeably connected to the printer head body 102.

In more detail, the openings 111 may comprise a first exit opening 112. The printer head arrangement 1 may further comprise an integer number, m, of fluid distribution arrangements. As illustrated in Figure 2B the fluid distribution arrangement comprises a first fluid distribution arrangement 6, see Figure 2C.

The first fluid distribution arrangement 6 is arranged to deposit a first fluid to the substrate via the first exit opening 112 of each of the nozzles 4. The printer head body 102 also comprises a first inlet supply channel 122 in fluid communication with the first exit opening 112 via the first fluid distribution arrangement 6.

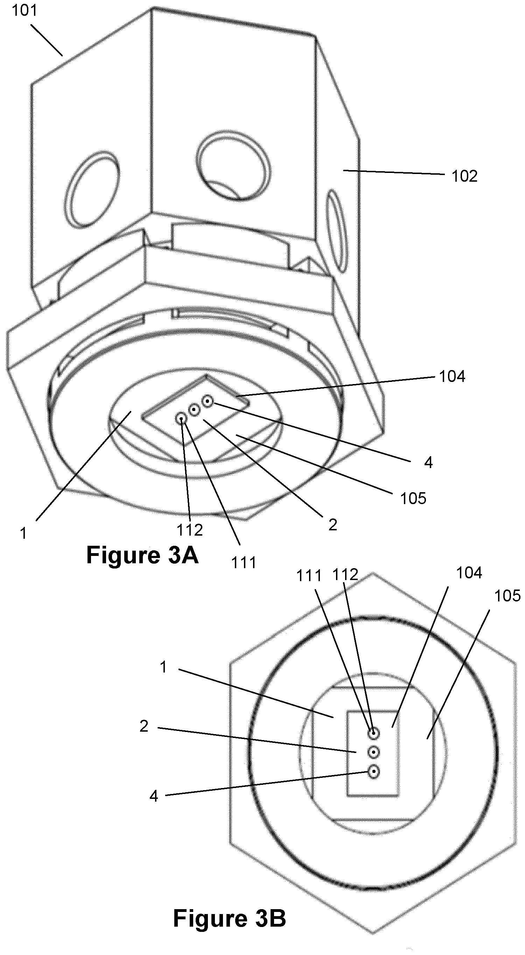

Figures 3A and 3B show an example of a printer head 101 wherein the printer head arrangement 1 is formed by the printer head plate 104 and an additional printer head plate 105. The printer head plate 104 may be removably attached to the additional printer head plate 105.

The printer head plate 104 and/or the additional printer head plate 105 may be removably attached to the printer head body 102 such that different printer head plates 104 can be connected to the printer head body 102.

The different printer head plates 104 may have different nozzles 4. The nozzles 4 may, by way of example, have varying sizes of the opening diameter of the first exit opening 112.

The array of nozzles 2 is here illustrated to have three nozzles 4 arranged in a row. It should be realized that the number of nozzles could be more than three. To this end, each nozzle 4 comprises an integer number, n, of openings 111. The number of openings is for clarity in the Figures illustrated to be 1, i.e. n=1, but could in other examples be more than one, i.e. n>1.

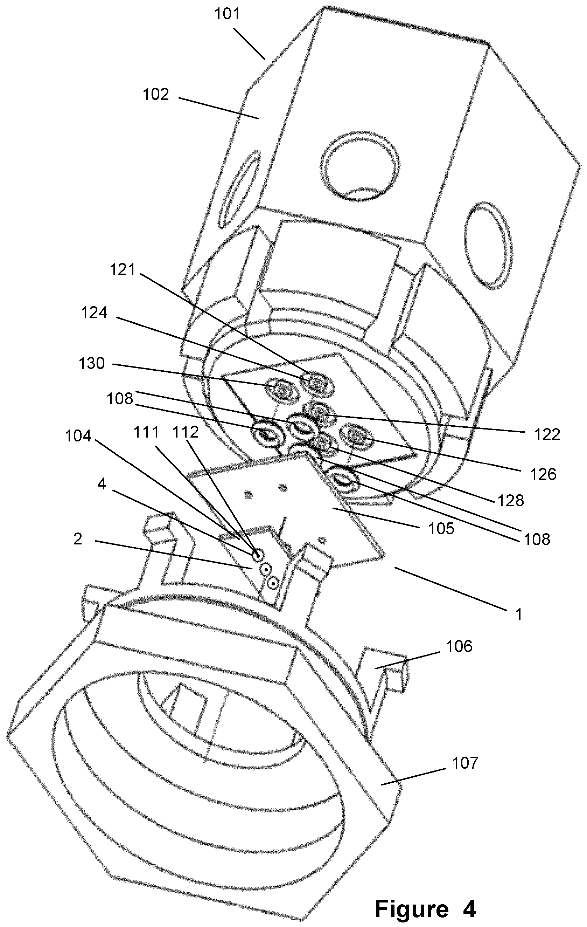

Figure 4 shows an exploded view of the printer head 101 of Figures 3A and 3B. With reference to Figures 3A, 3B and 4, the example of a printer head 101 is discussed. The printer head 101 comprises a printer head body 102 with a number of inlet supply/outlet channels 121, a printer head plate 104 with a number of openings 111, an additional printer head plate 105, a printer head plate clamp 106, and a clamping nut 107.

As described, the printer head arrangement 1 is formed by a printing head plate 104 and an additional printing head plate 105.The printer head plate 104 may be connected to the additional printer head plate 105, which in turn may be releasably fixed to a printer head plate clamp 106 and a clamping nut 107. The clamping nut 107 and the printer head plate clamp 106 may be separated from the printer head 101, which allows for an easy removal and/or change of printer head plate 104 and/or the additional printer head plate 105. The clamping nut 107 may be fixed to the printer head body 102 by a screw connection, a bayonet connection, a snap fit connection or similar. The printer head plate 104 is removably attached to the printer head 101 such that different printer head plates 104 can be connected to the printer head 101, the different printer head plates 104 having varying sizes of the opening diameter of the first exit opening. This allows for obtaining different atomic resolutions using the same printer.

O-rings 108 may be used between the additional printer head plate 105 and the printer head body 102 for ensuring a tight connection.

Alternatively, the printer head plate 104 may simply be soldered to a piece of metal. In this type of setup, there is no need for a clamp.

The printer head 101 comprises a printer head arrangement 1 and a printer head body 102. The printer head body 102 may comprise a number of inlet supply/outlet channels 121.

The inlet supply/outlet channels 121 may include both inlet supply channels 122, 124, 126 and outlet channels 128, 130.

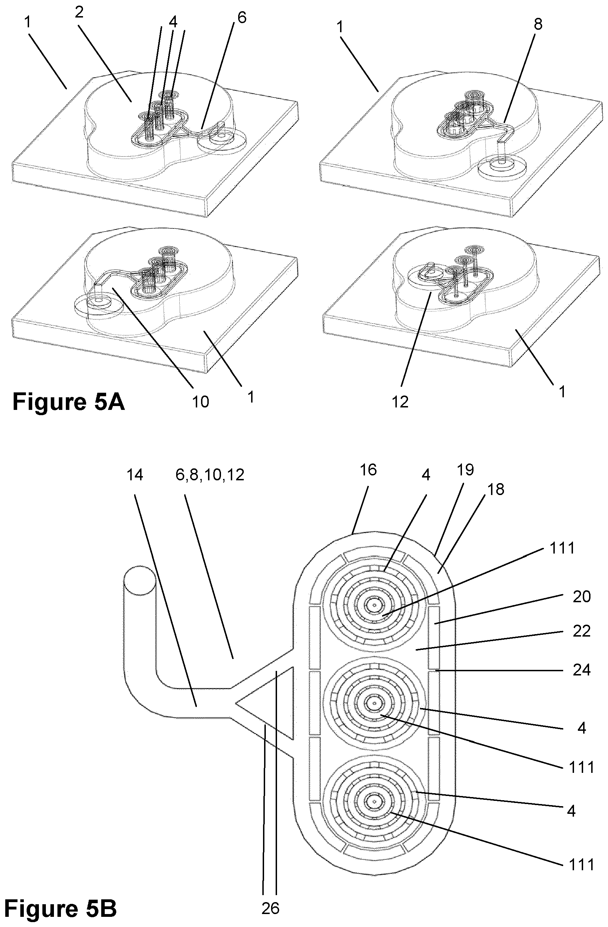

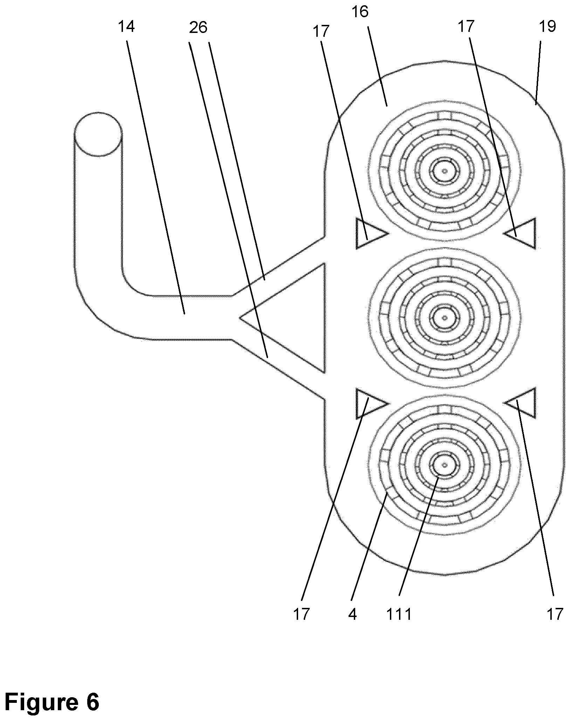

Figures 5A, 5B and 6 show the printer head arrangement 1 in more detail. As shown in Figure 5A the fluid distribution arrangements 6, 8, 10, and the exhaust collector arrangement 12 may be stacked on top of each other within the printer head arrangement 1. This stacking allows the fluid distribution arrangements 6, 8, 10 and the exhaust collector arrangement 12 to be connected to all individual nozzles 4 of the array of nozzles 2.

Figure 5B shows a close-up of the array of nozzles 2. Figure 5B shows an example how the fluid distribution arrangements 6, 8, 10 and the exhaust collector arrangement 12 are connected to the nozzles 4 of the array of nozzles 2.

Each of the fluid distribution arrangements 6,8,10 comprises a fluid distribution channel 14 and a common fluid chamber 16, the common fluid chamber 16 being in fluid communication with the fluid distribution channel 14 and being arranged to distribute the first fluid 132, the second fluid 134 or the inert fluid 136, to all nozzles 4 of the array of nozzles 2.

The first fluid is a first precursor fluid.

The second fluid is a second precursor fluid.

Referring to Figure 5B it is illustrated that the common fluid chamber 16 may comprise an outer chamber 18; a distribution wall 20; and an inner chamber 22. The outer chamber 18 is in fluid communication with the fluid distribution channel 14. The distribution wall 20 separates the inner chamber 22 from the outer chamber 18. The outer chamber 18 has an outer wall 19.

The distribution wall 20 comprises fluid passages 24 for fluid communication between the outer chamber 18 and the inner chamber 22.

The distribution wall 20 separates an inner wall of the inner chamber 22 and an outer wall of the outer chamber 18. The channels formed between the walls allow of fluid passages. In other words, fluid may flow in the circumference of the common fluid chamber 16 allowing for an improved distribution of fluid. The distribution of fluid to the respective nozzles 2 may thereby be improved.

The fluid passages 24 are arranged such that their dimensions are set to not hinder the mass transport of fluid, but to reduce the velocity of the fluid.

Referring to Figure 6, the common fluid chamber 16 comprises one or more fluid flow dividers 17 arranged to disperse, within the common fluid chamber 16, fluid from the fluid distribution channel 14 to the nozzles 4 of the array of nozzles 2. The fluid flow dividers 17 are an alternative way to the distribution wall 20 to distribute fluid in the common chamber 16 to the nozzles 4 of the array of nozzles 2. However, it is obvious for a person skilled in the art that the fluid flow dividers 17 may be combined with the distribution wall 20 to adjust the fluid flow in the common chamber 16.

The one or more fluid dividers 17, the distribution wall 20, fluid passages 24 and/or the outer wall 19 are arranged to increase the uniformity of the flow of fluid inside this common fluid chamber 16.

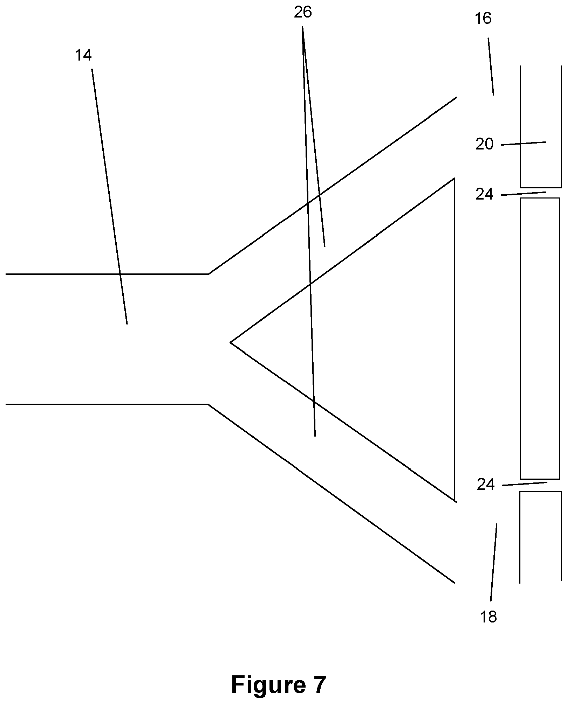

The fluid distribution channel 14 may be Y-shaped whereby two channels 26 are in fluid communication with the common fluid chamber 16. For clarity, Figure 7 shows a close-up view of the fluid distribution channel 14.

The Y-shape allows for the fluids to be split up into two streams. The fluids are thereby led into the common fluid chamber in an efficient manner. It may be noted that the Y-shaped fluid distribution channel is arranged such that none of the exit openings are in a direct flow path from the two channels 26.

Put differently, the common fluid chambers 16 are shared by all three nozzles. As a result, the fluid, e.g. the gas, and pressure can equalize and stabilize within the common fluid chamber, and so all 3 nozzles, and exit openings 111 will experience the same environment.

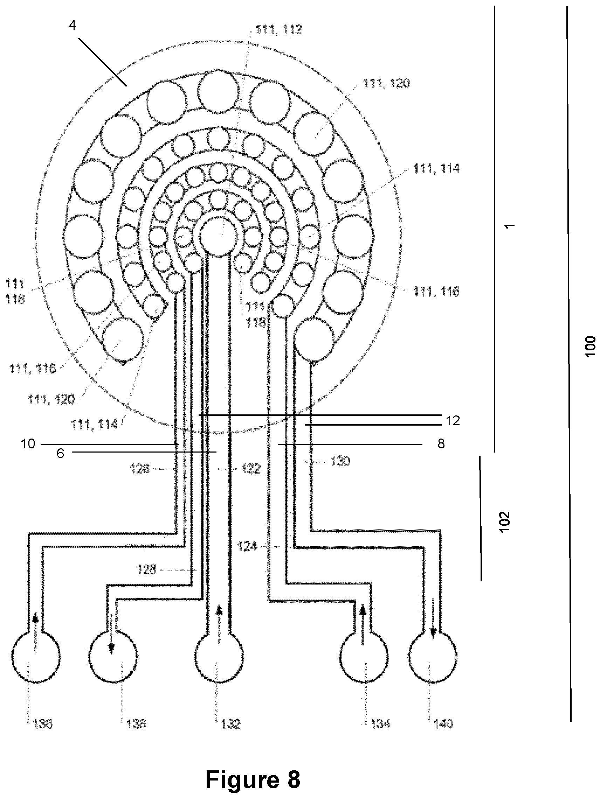

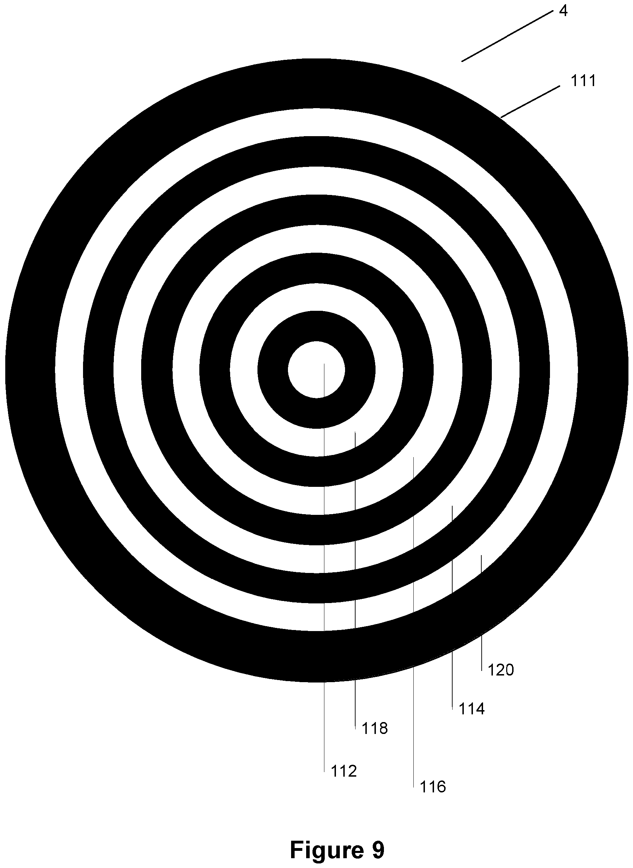

Figures 8 and 9 show different example of positions of the openings 111 in the printer head plate 104 with figure 4 also showing an example of how the inlet supply channels 122, 124, 126 and outlet channels 126, 128 can be connected to the openings 111 in the printer head plate 104.

Figure 8 illustrates schematically the fluid communication between different parts of the printer 100.

By way of example, the openings 111 may in addition to the first exit opening 112 further comprise a second exit opening 114 and a third exit opening 116.

The fluid distribution arrangements may in accordance further comprise: a second fluid distribution arrangement 8. The second fluid distribution arrangement 8 is arranged to deposit a second fluid 134 to the substrate 162 via the second exit opening 114 of each of the nozzles 4. To this end, and the fluid distribution arrangements may comprise a third fluid distribution arrangement 10. The third fluid distribution arrangement 10 is arranged to distribute an inert fluid 136 to the substrate 162 via the third exit opening 116 of each of the nozzles 4. The printer head body 102 may further comprise a second inlet supply channel 124 in fluid communication with the second exit opening 114 via the second fluid distribution arrangement 8 and a third inlet supply channel 126 in fluid communication with the third exit opening 116 via the third fluid distribution arrangement 10.

It is further illustrated in Figure 8, that the printer head arrangement 1 may comprise an exhaust collector arrangement 12 arranged to collect and remove non-deposited first and second fluids 138,140 and inert fluid 136 from the substrate 162 via one or more exhaust openings 118,120 of each nozzle 4. The printer head body 102 may further comprise one or more outlet channels 128,130 in fluid communication with the exhaust opening 118,120 via the exhaust collector arrangement 12.

Figure 9 shows a bottom-up view of an example of a nozzle 4, wherein the openings 111 are arranged in a ring-like geometry. In more detail, the first exit opening 112, the second exit opening 114, the third exit opening 116, the first exhaust opening 118, and the second exhaust opening 120 are all ring-shaped. A multiple of second exit openings 114, the third exit openings 116, the first exhaust openings 118, and the second exhaust openings 120 each arranged in a concentric setup around the first exit opening 112 are combined into one large ring-shaped opening for each of the second exit opening 114, the third exit opening 116, the first exhaust opening 118, and the second exhaust opening 120.

The first exit opening diameter of all first exit openings 112 in all the shown examples of printer heads in Figures 2-5 and 8-9 are smaller than 900 µm.

In one or more examples, the first exit opening diameter is in a range of 0.005-850 µm, such as 0.005-750 µm, such as 0.005-650 µm, such as 0.005-550 µm, such as 0.005-450 µm, such as 0.005-250 µm, such as 0.005-100 µm, such as 0.01-50 µm, such as 0.01-10 µm, such as 0.01-1 µm, such as 0.015-0.05 µm, such as 0.02 µm.

The printer will normally be able to provide a pattern resolution of 20 nm - 1 mm. The resolution of the printed structure, i.e. the resolution size, may depend on both the diameter of the one or more first exit openings and the distance between the printer head and the substrate plate.

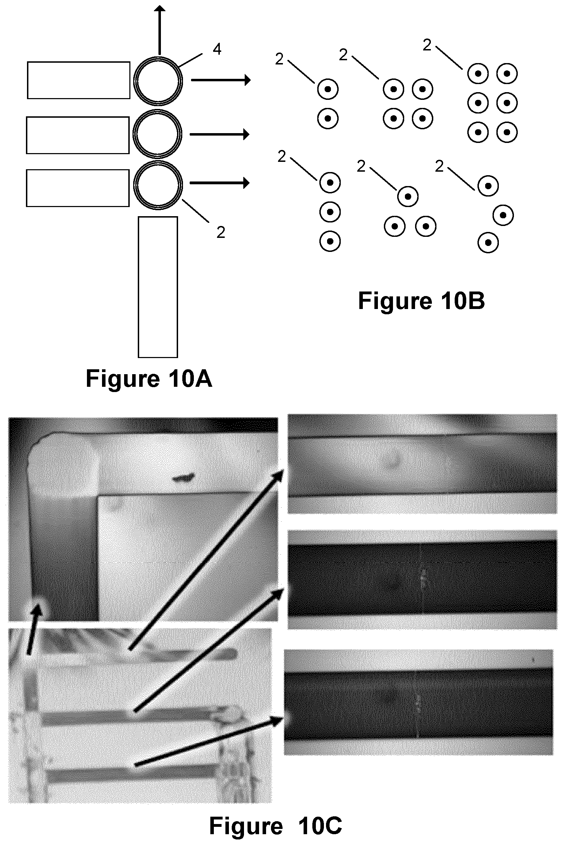

Figure 10A illustrates schematically material deposition with an array of nozzles 2 comprising three nozzles 4. A deposition may be done in a direction yielding three spatially separate parallel lines, the three arrows pointing right. A deposition may be done in the perpendicular direction yielding a continuous line, the arrow pointing up.

This schematic illustration shows that by this particular choice of the array of nozzles 2, three spatially separate lines may be deposited simultaneously, the three arrows pointing right. The distances between the lines may be set by the distances between the individual nozzles 4.

Three line segments along the same axis may be deposited simultaneously, the arrow pointing up. The three line segments may be either disconnected, connected forming a single continuous line or be on top of each other forming a single continuous line with the thickness of three times the thickness of an individual line segment.

It is obvious for a person skilled in the art that by first rotating, prior to printing, the substrate holder and the printed head relative to each other around the Z axis, perpendicular to Figure 10A, a single line or three spatially separate lines can be printed along any axis in the X,Y plane, Figure 10A defining the X,Y plane.

Furthermore, by a continuous rotation of the substrate holder and the printer head relative to each while printing, three spatially separate curved arcs may be obtained. The rotation may be a rotation of the substrate holder 160 while the printer head 101 remains stationary. The rotation may alternatively be a rotation printer head 101 while keeping the substrate holder 160 stationary. The rotation may also be a rotation of both the printer head 101 and the substrate holder 160.

Figure 10B shows schematically six different arrays of nozzles according to some examples. By way of example, nozzle arrays comprising 1x2, 2x2, 2x3, 1x3 arrangements are illustrated. To this end a triangular and a curved arrangement of nozzles in the array of nozzles are illustrated. The skilled person realizes that other number or arrangements of nozzles may be provided. Both the number of nozzles and their geometric configuration may be varied.

Figure 10C shows a micrograph of deposited three spatially separate lines and a single continuous line.

The lower left-hand side micrograph shows a two-step deposition of lines with an array of nozzles 2 comprising three nozzles 4. First, a single continuous line is deposited in the upward direction followed by a deposition of three spatially separate lines towards the horizontal direction. The distances between the adjacent three horizontal lines demonstrate the pitch of the three nozzles in this experimental example.

The upper left-hand side micrograph shows a zoom-in of the corner section connecting the single continuous line to the uppermost line of the three spatially separate horizontal lines.

The three right-hand side micrographs show zoom-ins of the three spatially separate horizontal lines from the lower left-hand side micrograph.

The second aspect of this disclosure shows a printer head arrangement 1 for enabling material deposition, etching, doping and/or cleaning on an atomic scale in a selective area of a substrate 162 when used in an atomic layer process printer 100.

With references to the above, the printer head arrangement 1 comprising an array of nozzles 2, each nozzle 4 comprising a number of openings 111, the openings 111 comprising: a first exit opening 112; and wherein the printer head arrangement 1 further comprises: a first fluid distribution arrangement 6 arranged to deposit a first fluid 132 to the substrate 162 via the first exit opening 112 of each of the nozzles 4.

The openings 111 further comprises: a second exit opening 114; and a third exit opening 116; wherein the printer head arrangement 1 further comprises: a second fluid distribution arrangement 8 arranged to deposit a second fluid 134 to the substrate 162 via the second exit opening 114 of each of the nozzles 4; a third fluid distribution arrangement 10 arranged to distribute an inert fluid 136 to the substrate 162 via the third exit opening 116 of each of the nozzles 4.

In an exemplary implementation, the precursor fluids used in the ALD, or ALE can be, for example, at least one of: Trimethylaluminum (TMA), Tetrakis(dimethylamino)titanium (TDMAT), Bis(cyclopentadienyl)zirconium(IV) dichloride (Cp2ZrCl2), Tetrakis(ethylmethylamino)hafnium (TEMAH), and Bis(ethylcyclopentadienyl)ruthenium(II) (Ru(EtCp)2), Titanium tetrachloride (TiCl4), Tungsten hexafluoride (WF6), Hafnium tetrachloride (HfCl4), Ruthenium trichloride (RuCl3), and Molybdenum hexacarbonyl (Mo(CO)6), Diethyl zinc (DEZ), Dimethylamino magnesium (DMAMg), Bis(cyclopentadienyl)iron(II) (Cp2Fe), Triisobutylaluminum (TIBA), Tetrakis(trimethylsilyl)hafnium (TTHf), Aluminum isopropoxide (Al(O-iPr)3), Titanium isopropoxide (Ti(O-iPr)4), Zirconium n-propoxide (Zr(O-nPr)4), Hafnium ethoxide (Hf(OEt)4), Tantalum ethoxide (Ta(OEt)5), Bis(t-butylamino)silane (BTBAS), Bis(t-butylamino)zinc (BTBAS2), Bis(t-butylamino)titanium (BTBAT), Bis(t-butylamino)zirconium (BTBZ), Bis(tbutylamino) hafnium (BTBAH), Dimethylcyclopentadienyl platinum (MeCpPtMe3), Bis(methylcyclopentadienyl)nickel (Ni(MeCp)2), Cyclopentadienyltungsten tricarbonyl (CpW(CO)3), Dimethylcyclopentadienyl manganese tricarbonyl (MeCpMn(CO)3), and Ironpentacarbonyl (Fe(CO)5).

The inert fluid can be at least one of: Nitrogen, Argon, Helium, and Neon. The inert fluid is preferably Argon but it is noted that the choice of inert fluid depends on factors such as process requirements, film properties, equipment capabilities, and cost considerations. Additionally, the use of other inert fluid or fluid mixtures may be used. The inert fluid may be an inert gas.

The person skilled in the art realizes that the present disclosure is not limited to the preferred examples described above. The person skilled in the art further realizes that modifications and variations are possible within the scope of the appended claims. Additionally, variations to the disclosed examples can be understood and effected by the skilled person in practicing the claimed disclosure, from a study of the drawings, the disclosure, and the appended claims.

## Claims

1. An atomic layer process printer (100) for material deposition, etching, doping and/or cleaning on an atomic scale in a selective area, the printer (100) comprising:
a substrate holder (160) for holding a substrate (162) where onto one or more fluids (132, 134) are deposited using the atomic layer process printer (100);
a printer head (101) positioned opposite the substrate holder (160), the substrate holder (160) being movable in relation to the printer head (101);
wherein the printer head (101) comprises a printer head arrangement (1) and a printer head body (102), the printer head arrangement (1) comprising an array of nozzles (2), wherein each nozzle (4) comprises an integer number, n, of openings (111), the openings (111) comprising:
a first exit opening (112);
wherein the printer head arrangement (1) further comprises an integer number, m, of fluid distribution arrangements, the fluid distribution arrangements comprising:
a first fluid distribution arrangement (6) arranged to deposit a first fluid (132) to the substrate (162) via the first exit opening (112) of each of the nozzles (4);
wherein the printer head body (102) comprises:
a first inlet supply channel (122) in fluid communication with the first exit opening (112) via the first fluid distribution arrangement (6).

2. The atomic layer process printer (100) according to claim 1, wherein
the openings (111) further comprises:
a second exit opening (114);
a third exit opening (116); and
wherein the fluid distribution arrangements further comprise:
a second fluid distribution arrangement (8) arranged to deposit a second fluid (134) to the substrate (162) via the second exit opening (114) of each of the nozzles (4); and
a third fluid distribution arrangement (10) arranged to distribute an inert fluid (136) to the substrate (162) via the third exit opening (116) of each of the nozzles (4);
wherein the printer head body (102) further comprises:
a second inlet supply channel (124) in fluid communication with the second exit opening (114) via the second fluid distribution arrangement (8);
a third inlet supply channel (126) in fluid communication with the third exit opening (116) via the third fluid distribution arrangement (10).

3. The atomic layer process printer (100) according to claim 2, wherein the printer head arrangement (1) comprises:
an exhaust collector arrangement (12) arranged to collect and remove non-deposited first and second fluids (138, 140) and inert fluid (136) from the substrate (162) via one or more exhaust openings (118, 120) of each nozzle (4); and
wherein the printer head body (102) comprises:
one or more outlet channels (128, 130) in fluid communication with the exhaust openings (118, 120) via the exhaust collector arrangement (12).

4. The atomic layer process printer (100) according to claim 2 or 3, wherein each of the fluid distribution arrangements (6, 8, 10) comprises a fluid distribution channel (14) and a common fluid chamber (16), the common fluid chamber (16) being in fluid communication with the fluid distribution channel (14) and being arranged to distribute the first fluid (132), the second fluid (134) or the inert fluid (136), to all nozzles (4) of the array of nozzles (2).

5. The atomic layer process printer (100) according to any one of claims 1 to 4, wherein the first fluid is a first precursor fluid.

6. The atomic layer process printer (100) according to any one of claims 2 to 5, wherein the second fluid is a second precursor fluid.

7. The atomic layer process printer (100) according to any one of claims 4 to 6, wherein the common fluid chamber (16) comprises one or more fluid flow dividers (17) arranged to disperse, within the common fluid chamber (16), fluid from the fluid distribution channel (14) to the nozzles (4) of the array of nozzles (2).

8. The atomic layer process printer (100) according to claim 4 or 7, wherein the common fluid chamber (16) comprises:
an outer chamber (18);
a distribution wall (20); and
an inner chamber (22);
wherein the outer chamber (18) is in fluid communication with the fluid distribution channel (14) and the distribution wall (20) separates the inner chamber (22) from the outer chamber (18), the distribution wall (20) comprising fluid passages (24) for fluid communication between the outer chamber (18) and the inner chamber (22).

9. The atomic layer process printer (100) according to any one of claim 4 to 8, wherein the fluid distribution channel (14) is Y-shaped whereby two channels (26) are in fluid communication with the common fluid chamber (16).

10. The atomic layer process printer (100) according to claim 2 to 6, wherein the fluid distribution arrangements (6, 8, 10) are stacked on top of each other within the printer head arrangement (1).

11. The atomic layer process printer (100) according to any one of claims 1 to 10, wherein the array of nozzles (2) comprises two or more nozzles (4) arranged in a row.

12. The atomic layer process printer (100) according to any one of claim 1 to 11, wherein the printer head arrangement (1) is formed in one piece of material.

13. The Atomic Layer Process Printer (100) according to any one of claims 1 to 12, wherein the printer head arrangement (1) is removably attached to the printer head body (102) such that printer head arrangement (1) can be interchangeably connected to the printer head body (102).

14. A printer head arrangement (1) for enabling material deposition, etching, doping and/or cleaning on an atomic scale in a selective area of a substrate (162) when used in an atomic layer process printer (100), the printer head arrangement (1) comprising an array of nozzles (2), each nozzle (4) comprising an integer number, n, of openings (111), the openings (111) comprising:
a first exit opening (112); and
wherein the printer head arrangement (1) further comprises:
a first fluid distribution arrangement (6) arranged to deposit a first fluid (132) to the substrate (162) via the first exit opening (112) of each of the nozzles (4).

15. The printing head arrangement according to claim 14, wherein the openings (111) further comprises:
a second exit opening (114); and
a third exit opening (116);
wherein the printer head arrangement (1) further comprises:
a second fluid distribution arrangement (8) arranged to deposit a second fluid (134) to the substrate (162) via the second exit opening (114) of each of the nozzles (4);
a third fluid distribution arrangement (10) arranged to distribute an inert fluid (136) to the substrate (162) via the third exit opening (116) of each of the nozzles (4).
